# EUROPEAN PATENT APPLICATION

(11) **EP 4 517 339 A1**
(43) Date of publication of application: **05.03.2025**
(21) Application number: 23796041.4
(22) Date of filing: 06.04.2023
(51) Int. Cl.: G01R 19/00

(54) **MEASURING SYSTEM**

(30) Priority: 28.04.2022 JP 2022074512
(71) Applicant: Nuvoton Technology Corporation Japan, Nagaokakyo City, Kyoto 617-8520 (JP)
(72) Inventor: MORI, Ryosuke, Nagaokakyo City, Kyoto 617-8520 (JP); ISHII, Takuya, Nagaokakyo City, Kyoto 617-8520 (JP)
(74) Representative: Novagraaf International SA
(86) International application number: PCT/JP2023/014266
(87) International publication number: WO 2023/210295

(57) **Abstract**

A measurement system includes: n measurement paths (measurement paths (11A), etc.) that output measurement data of one or more measurement objects, where n is an integer of four or greater; m reference signal generation circuits (BGR circuits (41), etc.) that output reference signals to be referenced by the n measurement paths, each of the m reference signal generation circuits outputting the reference signal to two or more measurement paths among the n measurement paths, where m is an integer of two or greater; k path anomaly detection circuits (determination circuits (15), etc.) that detect/confirm presence or absence of anomalies by comparing the measurement data output from two measurement paths among the n measurement paths, where k is an integer of two or greater; and a processing circuit (processing circuit (5D), etc.) that receives the measurement data output from the n measurement paths and outputs from the k path anomaly detection circuits as its inputs.

## Description

### [Technical Field]

The present disclosure relates to a measurement system.

### [Background Art]

In a typical fault diagnosis of measurement circuits, two measurement paths are provided for a single measurement object, and their outputs are compared. If the measurement results show a difference exceeding an allowable error, it is diagnosed that a fault has occurred in the measurement circuit. For example, the voltage detection device disclosed in Patent Literature (PTL) 1 includes two voltage detection units that selectively detect the voltage of each battery cell of a battery pack, and has a first mode for measuring voltages of different battery cells and a second mode for measuring the cell voltage of the same battery cell. In the second mode, if there is a difference in the measurement results, the device detects that some kind of fault has occurred in either of the voltage detection units.

### [Citation List]

### [Patent Literature]

[PTL 1] Japanese Unexamined Patent Application Publication No. 2013-24800

### [Summary of Invention]

### [Technical Problem]

However, the technique disclosed in PTL 1 has a problem in that when a failure occurs in, for example, a power supply that is commonly used by the two measurement paths, measurement data of the measurement object cannot be obtained.

In view of this, the present disclosure provides a measurement system that can obtain measurement data of the measurement object more reliably than conventional systems.

### [Solution to Problem]

A measurement system according to one aspect of the present disclosure includes: n measurement paths that output measurement data of one or more measurement objects, n being an integer of four or greater; m reference signal generation circuits that output reference signals to be referenced by the n measurement paths, each of the m reference signal generation circuits outputting a reference signal among the reference signals to two or more measurement paths among the n measurement paths, m being an integer of two or greater; k path anomaly detection circuits each of which detects/confirms presence or absence of an anomaly by comparing the measurement data output from two measurement paths among the n measurement paths, k being an integer of two or greater; and a processing circuit that receives the measurement data output from the n measurement paths and detection results output from the k path anomaly detection circuits as its inputs.

### [Advantageous Effects of Invention]

A measurement system according to one aspect of the present disclosure can obtain measurement data of the measurement object more reliably than conventional systems.

### [Brief Description of Drawings]

[FIG. 1A]

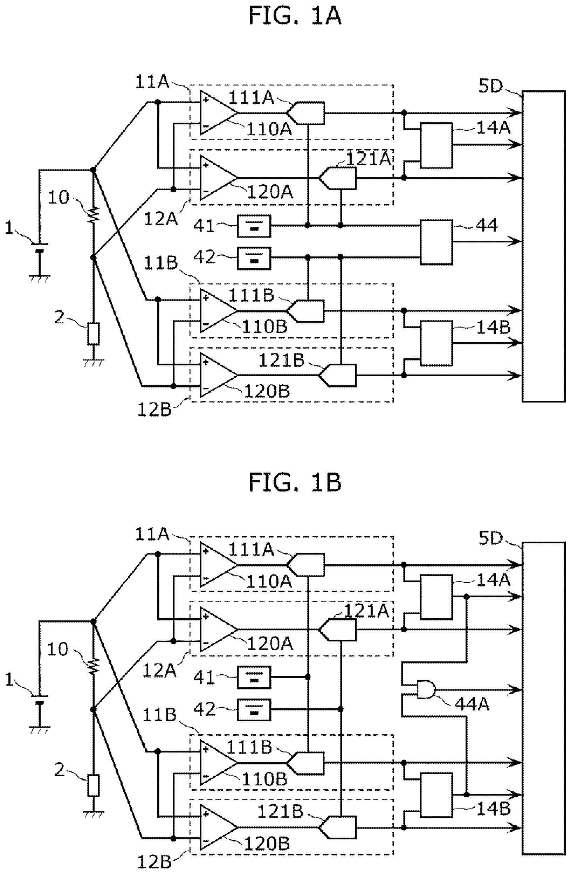

   FIG. 1A is a block diagram illustrating a first example of a circuit configuration of a measurement system according to Embodiment 1.
[FIG. 1B]
   FIG. 1B is a block diagram illustrating a second example of a circuit configuration of a measurement system according to Embodiment 1.
[FIG. 1C]

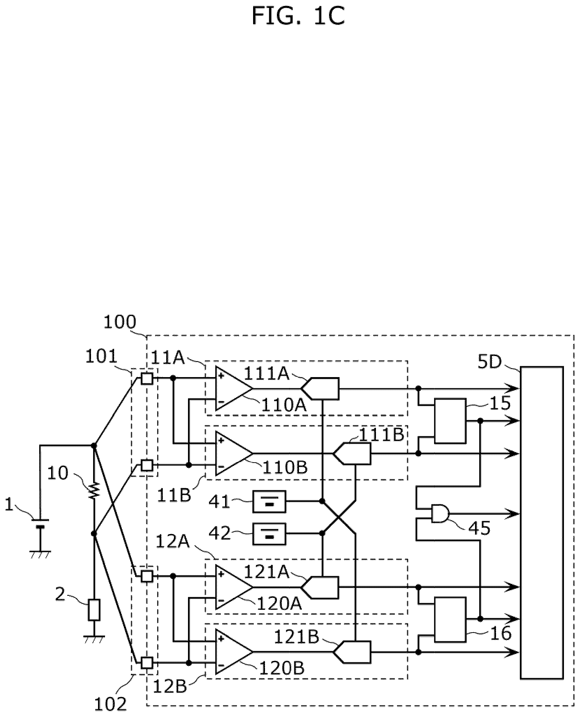

   FIG. 1C is a block diagram illustrating a third example of a circuit configuration of a measurement system according to Embodiment 1.
[FIG. 2A]

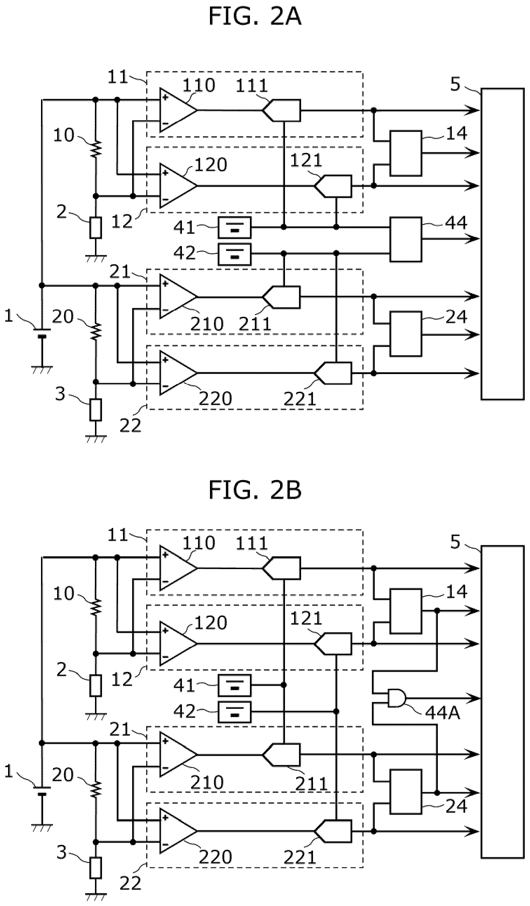

   FIG. 2A is a block diagram illustrating a first example of a circuit configuration of a measurement system according to Embodiment 2.
[FIG. 2B]
   FIG. 2B is a block diagram illustrating a second example of a circuit configuration of a measurement system according to Embodiment 2.
[FIG. 2C]

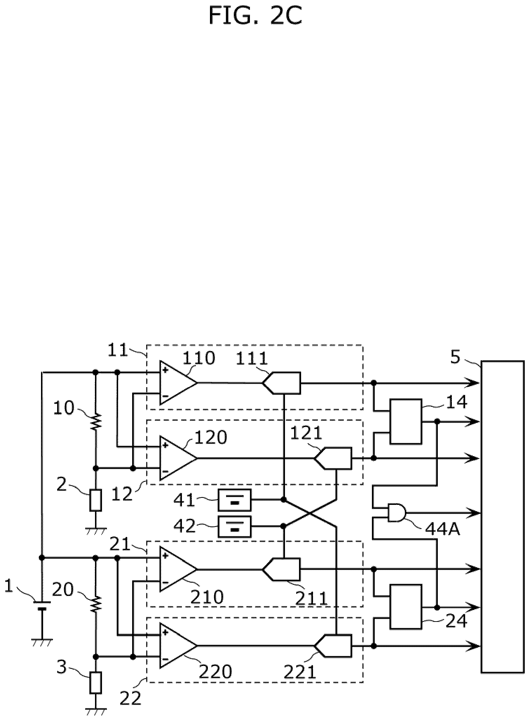

   FIG. 2C is a block diagram illustrating a third example of a circuit configuration of a measurement system according to Embodiment 2.
[FIG. 3]

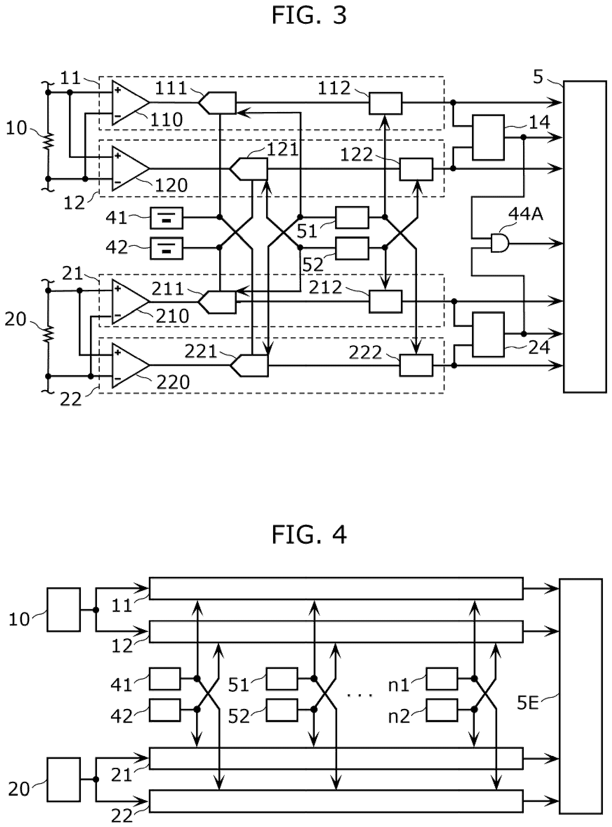

   FIG. 3 is a block diagram illustrating a circuit configuration of a measurement system according to Embodiment 3.
[FIG. 4]
   FIG. 4 is a block diagram illustrating a circuit configuration of a generalized measurement system according to Embodiment 3.
[FIG. 5A]

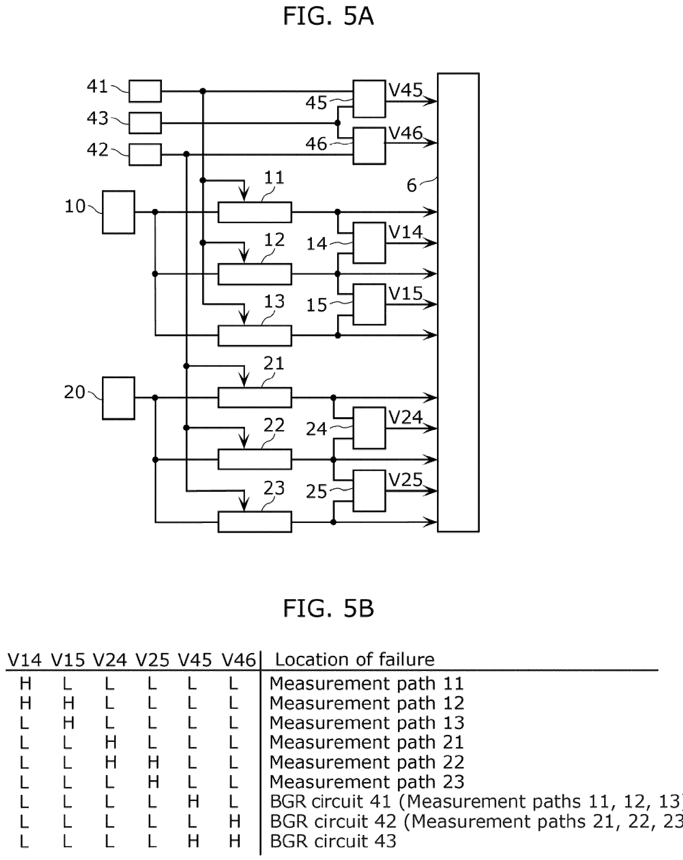

   FIG. 5A is a block diagram illustrating a circuit configuration of a measurement system according to Embodiment 4.
[FIG. 5B]
   FIG. 5B illustrates a truth table in the measurement system of FIG. 5A.
[FIG. 6A]

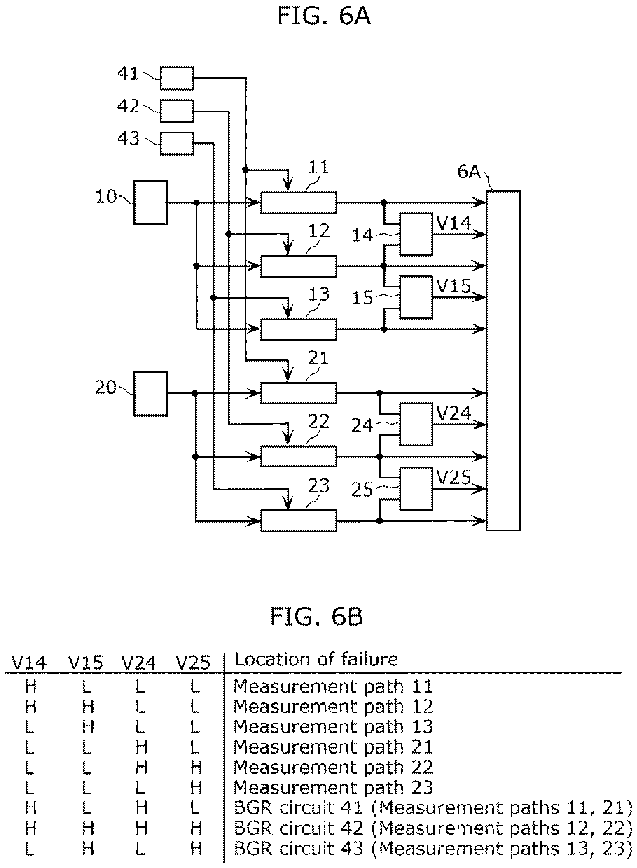

   FIG. 6A is a block diagram illustrating a circuit configuration of a measurement system according to Embodiment 5.
[FIG. 6B]
   FIG. 6B illustrates a truth table in the measurement system of FIG. 6A.
[FIG. 7A]

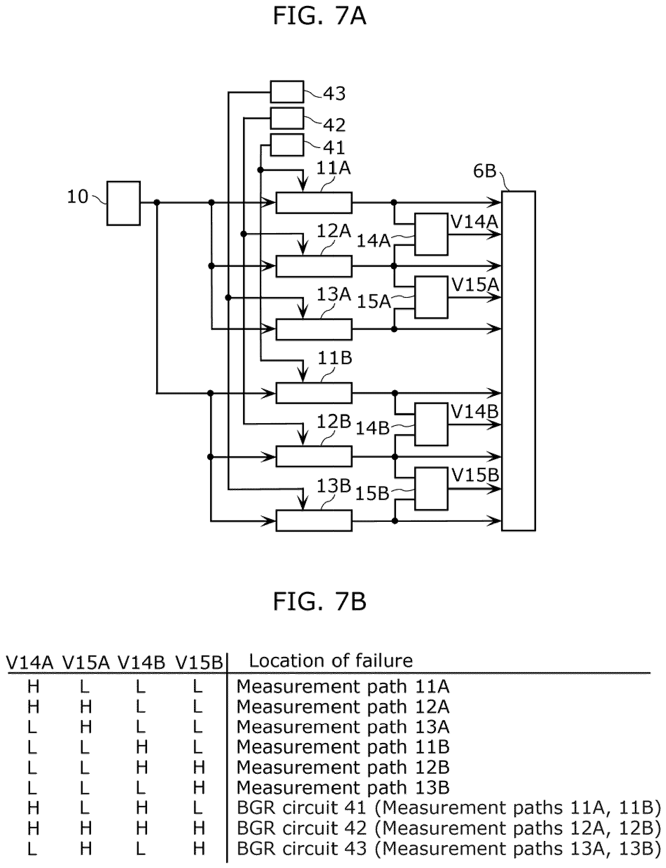

   FIG. 7A is a block diagram illustrating a first example of another circuit configuration of a measurement system according to Embodiment 5.
[FIG. 7B]
   FIG. 7B is a figure showing a truth table in the measurement system of FIG. 7A, showing the relationship between the outputs ("H" or "L" signals) of each detection circuit and the location of failure.
[FIG. 8A]

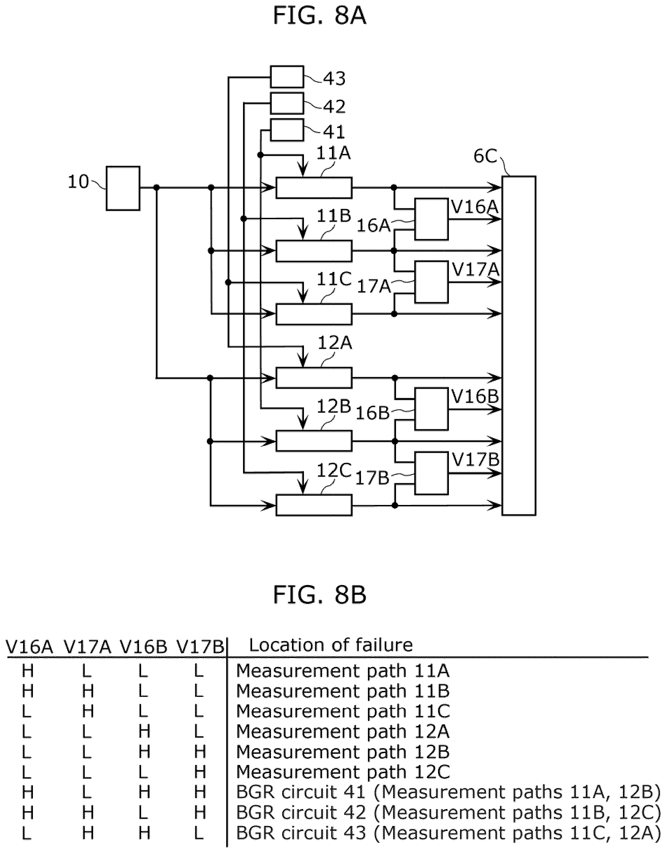

   FIG. 8A is a block diagram illustrating a second example of another circuit configuration of a measurement system according to Embodiment 5.
[FIG. 8B]
   FIG. 8B is a figure showing a truth table in the measurement system of FIG. 8A, showing the relationship between the outputs ("H" or "L" signals) of each detection circuit and the location of failure.
[FIG. 9A]

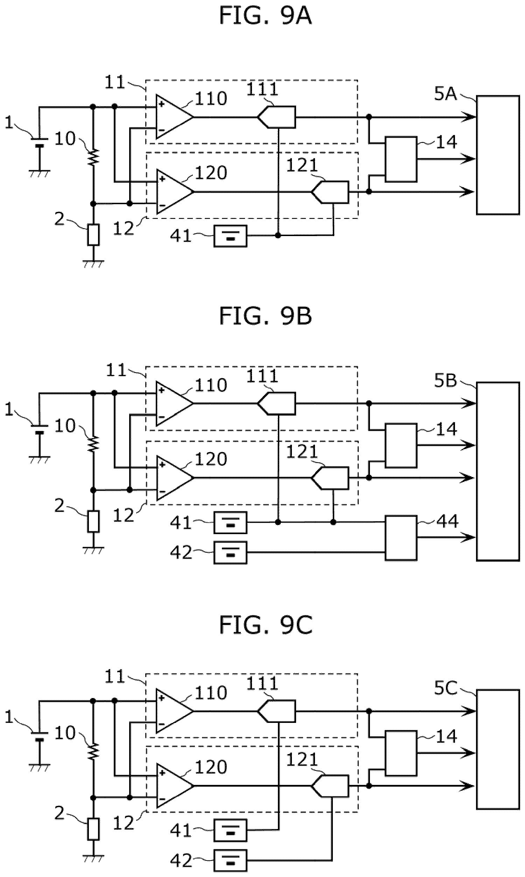

   FIG. 9A is a block diagram illustrating a first example of a circuit configuration of a measurement system according to a comparative example.
[FIG. 9B]
   FIG. 9B is a block diagram illustrating a second example of a circuit configuration of a measurement system according to a comparative example.
[FIG. 9C]
   FIG. 9C is a block diagram illustrating a third example of a circuit configuration of a measurement system according to a comparative example.

### [Description of Embodiments]

### Knowledge Leading to Present Disclosure

Prior to explaining the present disclosure, the knowledge that leads to the present disclosure will be described with reference to FIG. 9A through FIG. 9C.

First, the problem described above will be explained with reference to FIG. 9A. FIG. 9A is a block diagram illustrating a first example of a circuit configuration of a measurement system according to a comparative example. FIG. 9A illustrates measurement paths 11 and 12 that use resistor 10 to detect/measure a supply current for a circuit that supplies power from battery 1 to load circuit 2, and transmit the measurement data to processing circuit 5A.

As illustrated in FIG. 9A, the measurement system according to the first example includes measurement paths 11 and 12, detection circuit 14, bandgap reference (hereinafter abbreviated as BGR) circuit 41, and processing circuit 5A. Measurement path 11 includes amplifier 110 and analog-to-digital converter (hereinafter abbreviated as ADC) 111, and measurement path 12 includes amplifier 120 and ADC 121.

In measurement path 11, the voltage across both ends of resistor 10 is amplified by amplifier 110, and the output of amplifier 110 is converted to digital data and output by ADC 111. In measurement path 12, the voltage across both ends of resistor 10 is amplified by amplifier 120, and the output of amplifier 120 is converted to digital data and output by ADC 121.

The outputs of measurement paths 11 and 12 are compared in detection circuit 14, and if the difference is within a predetermined value, it is confirmed that neither of measurement paths 11 and 12 is anomalous, and "L" is output from detection circuit 14 to processing circuit 5A. However, if the difference exceeds the predetermined value, it is detected that either measurement path 11 or 12 is anomalous, and "H" is output from detection circuit 14 to processing circuit 5A. Therefore, if either of measurement paths 11 and 12 fails, detection circuit 14 detects there is a failure, and processing circuit 5A can issue a warning indicating that the input measurement data is unreliable. Note that "L" indicates a low level signal (for example, 0V) and "H" indicates a high level signal (for example, 5V), but the present disclosure is not limited to this example.

The reference voltage necessary for level determination of the measurement data in each of ADC 111 and 121 is generated by BGR circuit 41. If BGR circuit 41 fails, the outputs of each of measurement path 11 and 12 will also be anomalous values, but there will be no difference between them, and detection circuit 14 cannot detect there is a failure. Note that the reference voltage is one example of a reference signal.

To overcome this problem, two reference signals of, for example, the power supplies used on measurement paths 11 and 12 should be used, and a detection circuit for comparing the two reference signals should be provided. A measurement system which overcomes this problem will be described with reference to FIG. 9B. FIG. 9B is a block diagram illustrating a second example of a circuit configuration of a measurement system according to a comparative example.

As illustrated in FIG. 9B, the measurement system according to the second example includes a configuration in which BGR circuit 42, which generates the same reference voltage as BGR circuit 41, and detection circuit 44, which compares the reference voltages output by BGR circuits 41 and 42 and outputs the presence or absence of an anomaly, are added to the measurement system illustrated in FIG. 9A. Compared to processing circuit 5A, processing circuit 5B further receives the output from detection circuit 44 as its input. Processing circuit 5B includes, in addition to the functions of processing circuit 5A, processing functionality corresponding to the output from detection circuit 44.

Accordingly, if either of measurement paths 11 and 12 fails, detection circuit 14 detects there is a failure, and if either of BGR circuits 41 and 42 fails, detection circuit 44 detects there is a failure, and processing circuit 5B can issue a warning indicating that the input measurement data is unreliable.

However, in this configuration, if the reference signal that is commonly referenced by each of measurement path 11 and 12 is anomalous, all of the plurality of measurement paths 11 and 12 provided will be rendered inoperable. Stated differently, in the measurement system illustrated in FIG. 9B, if the reference signal is anomalous, measurement cannot be continued.

Note that in the above description and in the figures, it is indicated that the reference voltages to the ADCs are directly compared in detection circuit 44. However, since detection circuit 44 only needs to detect differences between BGR circuits 41 and 42, the configuration is not limited to this example. For example, each of BGR circuits 41 and 42 may output a signal corresponding to the reference voltage internally generated and output to detection circuit 44, and detection circuit 44 may detect/confirm the presence or absence of an anomaly by comparing these corresponding signals. This applies similarly to subsequent embodiments and drawings.

FIG. 9C is a block diagram illustrating a third example of a circuit configuration of a measurement system according to a comparative example.

As illustrated in FIG. 9C, the measurement system according to the third example includes a configuration in which BGR circuit 42 is added to the measurement system illustrated in FIG. 9A, and is configured such that the reference voltage of BGR circuit 41 is referenced by ADC 111, and the reference voltage of BGR circuit 42 is referenced by ADC 121. Stated differently, this is a solution that eliminates the reference signal commonly used in each measurement path 11 and 12 by including BGR circuit 41 in measurement path 11 and including BGR circuit 42 in measurement path 12. Note that processing circuit 5C includes the same functions as processing circuit 5A. Note that "referenced" means, for example, being used when processing (for example, AD conversion processing) is performed in a processing unit (for example, ADC 111).

However, this method has the problem of increasing circuit size when there is a plurality of or a plurality of types of measurement objects, measurement paths, or reference signals.

Here, measurement paths 11 and 12 may have the same measurement purpose or may have different measurement purposes. For example, when measurement paths 11 and 12 have the same measurement purpose, measurement accuracy can be improved by taking the average of both in processing circuits 5A to 5C. However, when the measurement purposes are different, for example, measurement path 11 is used to calculate and store the power consumption of load circuit 2 from the supply current, and measurement path 12 is used for overcurrent detection to protect battery 1 from anomalies in load circuit 2. Measurement paths 11 and 12 detect/measure the supply current to the same load circuit 2, but since their measurement purposes are different, the required accuracy, processing speed, and other factors may differ. The measurement purposes are not limited to current measurement, overcurrent detection, etc., and in the following explanation, they may be generally referred to as measurement purpose A, measurement purpose B, and so on.

In the measurement system illustrated in FIG. 9A, when BGR circuit 41 fails, and in the measurement system illustrated in FIG. 9B, when BGR circuit 41 or 42 fails, measurement data of the measurement object cannot be obtained. In view of this, the inventors diligently researched a measurement system that can continuously obtain measurement data of the measurement object even when a failure occurs in a BGR circuit or the like, and devised the measurement system described below.

Hereinafter, a measurement system according to embodiments will be described in detail with reference to the drawings. The embodiments described below each illustrate one specific example of the present disclosure. The numerical values, shapes, materials, elements, the arrangement and connection of the elements, etc., shown in the following embodiments are mere examples, and therefore do not limit the scope of the present disclosure. Accordingly, among the elements in the following embodiments, those not recited in any of the independent claims defining the broadest concept are described as optional elements.

The figures are not necessarily precise illustrations. In the figures, elements that are essentially the same share the same reference signs, and repeated description may be omitted or simplified in some cases.

In the present specification, terms indicating relationships between elements such as "same", numerical values, and numerical ranges refer not only to their strict meanings, but encompass a range of essentially equivalents, such as a range of deviations of a small percent (or approximately 10%).

The term "connection" with respect to elements means electrical connection, and includes not only cases where two elements are directly connected, but also cases where two elements are indirectly connected with other elements interposed between the two elements.

### [Embodiment 1]

First, a first example of the measurement system according to the present embodiment will be described with reference to FIG. 1A. FIG. 1A is a block diagram illustrating a first example of a circuit configuration of a measurement system according to the present embodiment. FIG. 1A illustrates measurement paths 11A, 12A, 11B and 12B that detect/measure a supply current from battery 1 to load circuit 2 using resistor 10 and transmit the supply current to processing circuit 5D. Resistor 10 is one example of a first measurement object, and includes a function of converting current supplied to load circuit 2 into voltage.

As illustrated in FIG. 1A, the measurement system according to the first example of present embodiment includes measurement paths 11A, 12A, 11B, and 12B, BGR circuits 41 and 42, detection circuits 14A, 14B, and 44, and processing circuit 5D. In the following, the plurality of measurement paths including measurement paths 11A, 12A, 11B, and 12B may also be referred to simply as "measurement paths 11A, etc.", and the plurality of ADCs including ADCs 111A, 121A, 111B, and 121B may be referred to simply as "ADCs 111A, etc.".

The measurement system can also be said to include four measurement paths 11, etc., (one example of n measurement paths), two BGR circuits 41 and 42 (one example of m reference signal generation circuits), detection circuits 14A and 14B (one example of k path anomaly detection circuits), and processing circuit 5D. The number of measurement paths included in the measurement system is not particularly limited as long as it is 4 or more (n is an integer of 4 or greater), the number of BGR circuits is not particularly limited as long as it is 2 or more (m is an integer of 2 or greater), and the number of detection circuits is not particularly limited as long as it is 2 or more (k is an integer of 2 or greater).

Measurement paths 11A and 12A are used for measurement purpose A, and measurement paths 11B and 12B are used for measurement purpose B, but the relationship between measurement paths and measurement purposes is not limited to this.

Each of measurement paths 11A, etc., detects/measures current using resistor 10, and transmits the measurement data to processing circuit 5D.

Measurement path 11A includes amplifier 110A and ADC 111A. In measurement path 11A, the voltage across both ends of resistor 10 is amplified by amplifier 110A, and the output of amplifier 110A is converted to digital data and output to processing circuit 5D by ADC 111A. Measurement path 11A is one example of a first measurement path.

Measurement path 12A includes amplifier 120A and ADC 121A. In measurement path 12, the voltage across both ends of resistor 10 is amplified by amplifier 120A, and the output of amplifier 120A is converted to digital data and output to processing circuit 5D by ADC 121A. Measurement path 12A is one example of a second measurement path.

Measurement path 11B includes amplifier 110B and ADC 111B. In measurement path 11B, the voltage across both ends of resistor 10 is amplified by amplifier 110B, and the output of amplifier 110B is converted to digital data and output to processing circuit 5D by ADC 111B. Measurement path 11B is one example of a third measurement path.

Measurement path 12B includes amplifier 120B and ADC 121B. In measurement path 12B, the voltage across both ends of resistor 10 is amplified by amplifier 120B, and the output of amplifier 120B is converted to digital data and output to processing circuit 5D by ADC 121B. Measurement path 12B is one example of a fourth measurement path.

ADC 111A, etc., may be, for example, a delta-sigma type ADC, a successive approximation register (SAR) type ADC, or an ADC of another type.

Each of ADC 111A, etc., for example, converts the input voltage to digital data with the same number of bits, but is not limited to this. ADCs 111A, etc., may use the same time or mutually different times to perform AD conversion. Generally, ADCs obtain more accurate values when the AD conversion time is longer, so the time for performing AD conversion is appropriately determined according to the measurement purpose of the measurement path.

Detection circuit 14A is connected between (i) measurement paths 11A and 12A and (ii) processing circuit 5D, and detects whether or not there are anomalies in measurement paths 11A and 12A based on the output (digital value of measurement data) of measurement path 11A and the output of measurement path 12A. For example, detection circuit 14A compares the measurement data output from measurement paths 11A and 12A and detects whether or not there are anomalies in measurement paths 11A and 12A. Detection circuit 14A is one example of a path anomaly detection circuit (first path anomaly detection circuit).

Detection circuit 14B is connected between (i) measurement paths 11B and 12B and (ii) processing circuit 5D, and detects whether or not there are anomalies in measurement paths 11B and 12B based on the output (digital value of measurement data) of measurement path 11B and the output of measurement path 12B. For example, detection circuit 14B compares the measurement data output from measurement paths 11B and 12B and detects whether or not there are anomalies in measurement paths 11B and 12B. Detection circuit 14B is one example of a path anomaly detection circuit (second path anomaly detection circuit).

Detection circuits 14A and 14B confirm that there are no anomalies if the difference in measurement data is within a predetermined value, and detect that there are anomalies if the difference in measurement data is greater than the predetermined value, and output the detection result ("H" or "L" described above) to processing circuit 5D. Assuming that the measurement data is 10-bit data, detection circuits 14A and 14B may judge whether the difference in measurement data is within a predetermined value by, for example, checking whether a predetermined number of upper bits (for example, the upper 8 bits) match, or by checking whether the difference in the numerical values represented by the 10 bits is within a predetermined value.

When the AD conversion times in ADCs 111A and 121A are different, detection circuit 14A may compare (i) calculated data obtained by performing a calculation with a set of several digital data output from the ADC with the shorter AD conversion time and (ii) one digital data output from the ADC with the longer AD conversion time. The calculated data is the average value of the set of several digital data, but may also be the median value, the mode, or the like. The same applies to detection circuit 14B.

BGR circuit 41 is connected to ADCs 111A and 121A and detection circuit 44, and outputs the respective reference signals used in measurement paths 11A and 12A. BGR circuit 41 is one example of a first reference signal generation circuit.

BGR circuit 42 is connected to ADCs 111B and 121B and detection circuit 44, and outputs the respective reference signals used in measurement paths 11B and 12B. BGR circuit 42 is one example of a second reference signal generation circuit.

In this way, the reference voltages necessary for level detection of measurement data in ADCs 111A, etc., are generated by BGR circuits 41 and 42, where the reference voltage output by BGR circuit 41 is referenced by ADCs 111A and 121A, and the reference voltage output by BGR circuit 42 is referenced by ADCs 111B and 121B. Note that the reference voltage supplied by BGR circuit 42 and the reference voltage supplied by BGR circuit 41 are the same voltage.

Detection circuit 44 is connected between (i) BGR circuits 41 and 42 and (ii) processing circuit 5D, and detects whether or not there is a failure in either BGR circuit 41 or BGR circuit 42 based on the output (reference signal) of BGR circuit 41 and the output

(reference signal) of BGR circuit 42. Detection circuit 44 confirms that there is no anomaly if the difference in reference voltage is within a predetermined value, and detects that there is an anomaly if the difference in measurement data is greater than the predetermined value, and outputs the detection result ("H" or "L" described above) to processing circuit 5D. Detection circuit 44 is one example of a circuit anomaly detection unit (circuit anomaly detection circuit).

In the measurement system according to the first example of the present embodiment, the outputs of measurement paths 11A and 12A are compared in detection circuit 14A, and if the difference is within a predetermined value, it is confirmed that neither of measurement paths 11A and 12A is anomalous, and "L" is output from detection circuit 14A to processing circuit 5D. However, if the difference exceeds the predetermined value, it is detected that either measurement path 11A or 12A is anomalous, and "H" is output from detection circuit 14A to processing circuit 5D. Similarly, the outputs of measurement paths 11B and 12B are compared in detection circuit 14B, and the presence or absence of an anomaly is output from detection circuit 14B to processing circuit 5D. Furthermore, the reference voltages output by BGR circuits 41 and 42 are compared in detection circuit 44, and the presence or absence of an anomaly is output from detection circuit 44 to processing circuit 5D.

With the configuration described above, detection circuit 14A can detect there is a failure if there is an anomaly in measurement path 11A or 12A, detection circuit 14B can detect there is a failure if there is an anomaly in measurement path 11B or 12B, and detection circuit 44 can detect there is a failure if there is an anomaly in BGR circuit 41 or 42. Processing circuit 5D issues a warning indicating that the current measurement data from measurement paths 11A and 12A is unreliable when detection circuit 14A detects there is a failure, and similarly issues a warning indicating that the overcurrent detection data from measurement paths 11B and 12B is unreliable when detection circuit 14B detects there is a failure. When detection circuit 44 detects there is a failure, even if other detection circuits 14A and 14B have not detects there is a failure, processing circuit 5D can issue a warning that the reference voltage supplied to each circuit or measurement system is anomalous, and take measures such as stopping the operation of load circuit 2.

In the measurement system, even when detection circuit 14A detects there is a failure, measurement of measurement data can be continued using measurement paths 11B and 12B, and even when detection circuit 14B detects there is a failure, measurement of measurement data can be continued using measurement paths 11A and 12A.

Next, a second example of the measurement system according to the present embodiment will be described with reference to FIG. 1B. FIG. 1B is a block diagram illustrating a second example of a circuit configuration of a measurement system according to the present embodiment.

The measurement system illustrated in FIG. 1B is equivalent to the measurement system illustrated in FIG. 1A with a simplified detection circuit 44. The measurement system illustrated in FIG. 1B differs from the measurement system illustrated in FIG. 1A in that the reference voltage output by BGR circuit 41 is referenced by ADC 111A of measurement path 11A and ADC 111B of measurement path 11B, and the reference voltage output by BGR circuit 42 is referenced by ADC 121A of measurement path 12A and ADC 121B of measurement path 12B. This allows detection circuit 44A to be simplified. Detection circuit 44A can be implemented, for example, using an AND circuit. Detection circuit 44A receives the output from detection circuit 14A and the output from detection circuit 14B as its inputs.

Detection circuit 44A is connected to detection circuits 14A and 14B and processing circuit 5D, and detects whether either BGR circuit 41 or 42 is anomalous based on the output ("H" or "L") of detection circuit 14A and the output ("H" or "L") of detection circuit 14B. Detection circuit 44A outputs "H" to processing circuit 5D indicating that either BGR circuit 41 or 42 is anomalous when the outputs of both detection circuits 14A and 14B are "H", and outputs "L" to processing circuit 5D when at least one of the outputs of detection circuits 14A and 14B is "L". Detection circuit 44A is one example of a circuit anomaly detection unit.

In the configuration of FIG. 1B as described above, in two measurement paths having the same measurement purpose, reference voltages from different BGR circuits are referenced. For example, measurement paths 11A and 12A are measurement paths having the same measurement purpose, but measurement path 11A references a reference voltage from BGR circuit 41, and measurement path 12A references a reference voltage from BGR circuit 42. When an anomaly occurs in a BGR circuit, different reference voltages are referenced in the measurement paths, causing a difference in the output measurement data. As a result, both detection circuits 14A and 14B detect there is a failure and output "H" to each of detection circuit 44A and processing circuit 5D. Detection circuit 44A therefore outputs "H" to processing circuit 5D. Assuming that failures do not occur simultaneously in two locations, detection circuits 14A and 14B simultaneously detects there is a failure only when an anomaly occurs in one of BGR circuit 41 or 42. Stated differently, detection circuit 44A has a simpler configuration than detection circuit 44 illustrated in FIG. 1A, while having the same operation (function) as detection circuit 44.

Note that in order to achieve the advantageous effect of a simplified detection circuit 44, which ADC 111A, etc., references the reference voltage of which BGR circuit 41 and 42 is not limited to the connections illustrated in FIG. 1B. ADCs of different measurement paths handling measurement data for the same measurement purpose may be connected so as to reference reference voltages from different BGR circuits.

Next, a third example of the measurement system according to the present embodiment will be described with reference to FIG. 1C. FIG. 1C is a block diagram illustrating a third example of a circuit configuration of a measurement system according to the present embodiment. FIG. 1C illustrates another connection of ADC and BGR circuits, and is one example of a circuit configuration of a measurement system that includes, in integrated circuit 100, everything from measurement paths 11A, etc., (excluding resistor 10) to processing circuit 5D.

Integrated circuit 100 is formed by integrating terminal pair 101, terminal pair 102, measurement paths 11A, etc., detection circuits 15, 16, and 45, and processing circuit 5D.

In the embodiment illustrated in FIG. 1C, there are four measurement paths, so terminal pair 101 and terminal pair 102 to which the voltage across both ends of resistor 10, which is the measurement object, is applied are provided. Measurement paths 11A and 11B are connected to terminal pair 101, and measurement paths 12A and 12B are connected to terminal pair 102. Stated differently, the measurement system illustrated in FIG. 1C includes terminal pair 101 (one example of a first terminal pair) connected to measurement paths 11A and 11B, and terminal pair 102 (one example of a second terminal pair) connected to measurement paths 12A and 12B. This connection configuration assumes that separate measurement objects may be connected to each of the two terminal pairs 101 and 102, and is to accommodate both measurement purposes A and B for each of terminal pairs 101 and 102.

In FIG. 1C, the reference voltage output by BGR circuit 41 is referenced by ADC 111A of measurement path 11A and ADC 121B of measurement path 12B, and the reference voltage output by BGR circuit 42 is referenced by ADC 111B of measurement path 11B and ADC 121A of measurement path 12A. The outputs of measurement paths 11A and 11B are compared in detection circuit 15, and if the difference is within a predetermined value, it is confirmed that neither of measurement paths 11A and 11B is anomalous, and "L" is output from detection circuit 15 to processing circuit 5D. However, if the difference exceeds the predetermined value, it is detected that either measurement path 11A or 11B is anomalous, and "H" is output from detection circuit 15 to processing circuit 5D. Similarly, the outputs of measurement paths 12A and 12B are compared in detection circuit 16, and the presence or absence of an anomaly is output from detection circuit 16 to processing circuit 5D. Detection circuit 45 receives the output from detection circuit 15 and the output from detection circuit 16 as its inputs.

With this above configuration, since ADCs of two measurement paths for the same measurement purpose are connected so as to reference reference voltages from different BGR circuits, in addition to the advantageous effect of a simplified detection circuit 45 similar to FIG. 1B, it is possible to achieve a configuration including an integrated circuit having two sets of terminal pairs with two measurement purposes.

The measurement data output from measurement paths 11A and 12A may be used for measurement purpose A, and the measurement data output from measurement paths 11B and 12B may be used for measurement purpose B. Terminal pairs 101 and 102 may each be connected to different measurement objects. Stated differently, measurement paths 11A and 11B may measure a different measurement object than measurement paths 12A and 12B. In such cases, measurement paths 11A and 11B and measurement paths 12A and 12B are used for different measurement purposes, and reference signals are supplied from mutually different BGR circuits (BGR circuit 41 or 42) to measurement paths having the same measurement purpose (for example, to measurement paths 11A and 12A, and to measurement paths 11B and 12B).

### [Embodiment 2]

While Embodiment 1 described a measurement system for obtaining measurement data of one measurement object, the number of measurement objects to be measured may be two or more. Hereinafter, a measurement system capable of obtaining measurement data of two measurement objects will be described with reference to FIG. 2A through FIG. 2C. FIG. 2A is a block diagram illustrating a first example of a circuit configuration of a measurement system according to the present embodiment. The present embodiment includes resistors 10 and 20 as one or more measurement objects. Note that measurement paths 11 and 12 illustrated in FIG. 2A may have the same configuration as measurement paths 11A and 12A illustrated in FIG. 1A, and measurement paths 21 and 22 may have the same configuration as measurement paths 11B and 12B illustrated in FIG. 1A. Detection circuits 14 and 24 may have the same configuration as detection circuits 14A and 14B illustrated in FIG. 1A. Accordingly, detailed explanations of measurement paths 11, etc., and detection circuits 14 and 24 will be omitted.

FIG. 2A illustrates paths that supply power from battery 1 to two load circuits 2 and 3, and paths that each detect/measure supply current and transmit the measurement data to processing circuit 5.

Resistor 10 is connected so as to measure current supplied to load circuit 2, and the voltage across both ends of resistor 10 is transmitted to measurement paths 11 and 12.

In measurement path 11, the voltage across both ends of resistor 10 is amplified by amplifier 110, and the output of amplifier 110 is converted to digital data and output by ADC 111. In measurement path 12, the voltage across both ends of resistor 10 is amplified by amplifier 120, and the output of amplifier 120 is converted to digital data and output by ADC 121.

Resistor 20 is one example of a second measurement object, and converts current supplied to load circuit 3 into voltage, and the voltage across both ends of resistor 20 is transmitted to measurement paths 21 and 22. In measurement path 21, the voltage across both ends of resistor 20 is amplified by amplifier 210, and the output of amplifier 210 is converted to digital data and output by ADC 211. In measurement path 22, the voltage across both ends of resistor 20 is amplified by amplifier 220, and the output of amplifier 220 is converted to digital data and output by ADC 221.

Here, measurement paths 11 and 12 may be for the same type of measurement or may be for different types of measurement. When measurement paths 11 and 12 pertain to the same type of measurement, measurement accuracy can be improved by taking the average of both in processing circuit 5. However, for heterogeneous measurements, measurement path 11 can be used to calculate and store the power consumption of load circuit 2 from the supply current, and measurement path 12 can be used for overcurrent detection to protect battery 1 from anomalies in load circuit 2. Measurement paths 11 and 12 detect/measure the supply current to the same load circuit 2, but since their usage purposes are different, the required accuracy, processing speed, and other factors differ. This applies similarly to measurement paths 21 and 22, and to subsequent embodiments and drawings. Note that the same type of measurement means that the measurement purpose is the same, and different types of measurement means that the measurement purposes are different.

The reference voltages necessary for level determination of measurement data in ADCs 111, etc., are generated by BGR circuits 41 and 42, where the reference voltage output by BGR circuit 41 is referenced by ADCs 111 and 121, and the reference voltage output by BGR circuit 42 is referenced by ADCs 211 and 221. BGR circuits 41 and 42 output reference signals used in measurement paths for different measurement objects.

The outputs of measurement paths 11 and 12 are compared in detection circuit 14, and if the difference is within a predetermined value, it is confirmed that neither of measurement paths 11 and 12 is anomalous, and "L" is output from detection circuit 14 to processing circuit 5. However, if the difference exceeds the predetermined value, it is detected that either or both of measurement paths 11 and 12 are anomalous, and "H" is output from detection circuit 14 to processing circuit 5. Similarly, the outputs of measurement paths 21 and 22 are compared in detection circuit 24, and the presence or absence of an anomaly is output from detection circuit 24 to processing circuit 5. Furthermore, the reference voltages output by BGR circuits 41 and 42 are compared in detection circuit 44, and the presence or absence of an anomaly is output from detection circuit 44 to processing circuit 5.

With the configuration described above, detection circuit 14 can detect there is a failure if there is an anomaly in measurement path 11 or 12, and detection circuit 24 can detect there is a failure if there is an anomaly in measurement path 21 or 22. Additionally, while detection circuits 14 and 24 cannot detect anomalies in BGR circuit 41 or 42 if there is an anomaly in BGR circuit 41 or 42, detection circuit 44 can detect there is a failure.

When detection circuit 14 detects there is a failure, processing circuit 5 can issue a warning that the supply current to load circuit 2 cannot be correctly detected/measured, and can take measures such as stopping the operation of load circuit 2. Similarly, when detection circuit 24 detects there is a failure, processing circuit 5 can issue a warning that the supply current to load circuit 3 cannot be correctly detected/measured, and can take measures such as stopping the operation of load circuit 3. When detection circuit 44 detects there is a failure, even if other detection circuits 14 and 24 have not detected there is a failure, processing circuit 5 can issue a warning that the reference voltage supplied to each circuit or measurement system is anomalous, and take measures such as stopping the operation of all load circuits.

Next, a second example of the measurement system according to the present embodiment will be described with reference to FIG. 2B. FIG. 2B is a block diagram illustrating a second example of a circuit configuration of a measurement system according to the present embodiment.

The measurement system illustrated in FIG. 2B is equivalent to the measurement system illustrated in FIG. 2A with simplified detection circuit 44. The measurement system illustrated in FIG. 2B differs from the measurement system illustrated in FIG. 2A in that the reference voltage output by BGR circuit 41 is referenced by ADC 111 of measurement path 11 and ADC 211 of measurement path 21, and the reference voltage output by BGR circuit 42 is referenced by ADC 121 of measurement path 12 and ADC 221 of measurement path 22. Detection circuit 44A, which is an AND circuit similar to the measurement system illustrated in FIG. 1B, receives the output from detection circuit 14 and the output from detection circuit 24 as its inputs.

BGR circuit 41 supplies reference voltage to ADCs 111 and 211. BGR circuit 41 supplies a common reference voltage to measurement paths 11 and 21, which have different measurement objects but the same measurement purpose. BGR circuit 42 supplies reference voltage to ADCs 121 and 221. BGR circuit 42 supplies a common reference voltage to measurement paths 12 and 22, which have different measurement objects but the same measurement purpose.

In the configuration of FIG. 2B as described above, in two measurement paths measuring the same measurement object, reference voltages from different BGR circuits are referenced. For example, measurement paths 11 and 12 are measurement paths for measuring the same measurement object, but measurement path 11 references a reference voltage from BGR circuit 41, and measurement path 12 references a reference voltage from BGR circuit 42. When an anomaly occurs in a BGR circuit, different reference voltages are referenced in the measurement paths, causing a difference in the output measurement data. As a result, both detection circuits 14 and 24 detect there is a failure and output "H" to detection circuit 44A and processing circuit 5. Detection circuit 44A therefore outputs "H" to processing circuit 5. Assuming that failures do not occur simultaneously in two locations, detection circuits 14 and 24 simultaneously detect there is a failure only when an anomaly occurs in one of BGR circuit 41 or 42. Stated differently, detection circuit 44A has a simpler configuration than detection circuit 44 illustrated in FIG. 2A, while being able to perform the same operation as detection circuit 44.

Note that with respect to the advantageous effect of a simplified detection circuit 44A, which ADC 111, etc., references the reference voltage of which BGR circuit 41 and 42 is not limited to the connections illustrated in FIG. 2B. ADCs of different measurement paths handling measurement data for the same measurement object may be connected so as to reference reference voltages from different BGR circuits.

Next, a third example of the measurement system according to the present embodiment will be described with reference to FIG. 2C. FIG. 2C is a block diagram illustrating a third example of a circuit configuration of a measurement system according to the present embodiment. FIG. 2C illustrates another example of the connection of ADCs and BGR circuits.

The measurement system illustrated in FIG. 2C differs from the measurement system illustrated in FIG. 2B in that the reference voltage output by BGR circuit 41 is referenced by ADC 111 of measurement path 11 and ADC 221 of measurement path 22, and the reference voltage output by BGR circuit 42 is referenced by ADC 121 of measurement path 12 and ADC 211 of measurement path 21.

BGR circuit 41 supplies reference voltage to ADCs 111 and 221. BGR circuit 41 supplies a common reference voltage to measurement paths 11 and 22, which have different measurement objects and different measurement purposes. BGR circuit 42 supplies reference voltage to ADCs 121 and 211. BGR circuit 42 supplies a common reference voltage to measurement paths 12 and 21, which have different measurement objects and different measurement purposes.

In FIG. 2C as well, since ADCs of two measurement paths for the same measurement object are connected so as to reference reference voltages from different BGR circuits, simplification of detection circuit 44A can be achieved similar to FIG. 2B. Furthermore, the configuration illustrated in FIG. 2C corresponds to the configuration of FIG. 1C in which ADCs of two measurement paths for the same measurement purpose are connected so as to reference reference voltages from different BGR circuits.

### [Embodiment 3]

Digital data output from an ADC in a measurement path is often subjected to processing such as calculation processing in a post-signal-processing circuit and latch processing to registers accessible from outside. In such cases, a sequencer circuit may be used in the measurement system to adjust various timings such as AD conversion output timing and various processing timings. The sequencer circuit generates various trigger signals in accordance with counter values of a counter synchronized with an internal system clock. The ADC, post-signal-processing circuit, etc., perform appropriate output, processing, and other operations by referencing these various trigger signals. Note that the post-signal-processing circuit is a processing circuit different from processing circuit 5 that is connected between the ADC and the processing circuit (for example, processing circuit 5 illustrated in FIG. 3). The various trigger signals are one example of a reference signal. Hereinafter, the post-signal-processing circuit may also be referred to as a post-signal-processing unit.

FIG. 3 is a block diagram illustrating a circuit configuration of a measurement system according to the present embodiment. The measurement system illustrated in FIG. 3 differs from the measurement system illustrated in FIG. 2C in that sequencer circuits 51 and 52 are provided to generate various trigger signals (hereinafter also referred to as reference signals) necessary for each ADC 111, etc., and each post-signal-processing unit 112, etc. Note that in FIG. 3, illustration of battery 1 and load circuits 2 and 3 is omitted for convenience.

Measurement path 11 includes amplifier 110, ADC 111, and post-signal-processing unit 112. Post-signal-processing unit 112 is connected between ADC 111 and processing circuit 5. In measurement path 11, the voltage across both ends of resistor 10 is amplified by amplifier 110, and the output of amplifier 110 is converted to digital data and output by ADC 111, and the output of ADC 111 is subjected to predetermined processing by post-signal-processing unit 112 and output to processing circuit 5.

Measurement path 12 includes amplifier 120, ADC 121, and post-signal-processing unit 122. Post-signal-processing unit 122 is connected between ADC 121 and processing circuit 5. In measurement path 12, the voltage across both ends of resistor 10 is amplified by amplifier 120, and the output of amplifier 120 is converted to digital data and output by ADC 121, and the output of ADC 121 is subjected to predetermined processing by post-signal-processing unit 122 and output to processing circuit 5.

Measurement path 21 includes amplifier 210, ADC 211, and post-signal-processing unit 212. Post-signal-processing unit 212 is connected between ADC 211 and processing circuit 5. In measurement path 21, the voltage across both ends of resistor 20 is amplified by amplifier 210, and the output of amplifier 210 is converted to digital data and output by ADC 211, and the output of ADC 211 is subjected to predetermined processing by post-signal-processing unit 212 and output to processing circuit 5.

Measurement path 22 includes amplifier 220, ADC 221, and post-signal-processing unit 222. Post-signal-processing unit 222 is connected between ADC 221 and processing circuit 5. In measurement path 22, the voltage across both ends of resistor 20 is amplified by amplifier 220, and the output of amplifier 220 is converted to digital data and output by ADC 221, and the output of ADC 221 is subjected to predetermined processing by post-signal-processing unit 222 and output to processing circuit 5.

Note that the predetermined processing in post-signal-processing unit 112, etc., may be the same processing or may be mutually different processing.

The reference signal output by sequencer circuit 51 is referenced by at least one of (i) ADCs 111 and 221 or (ii) post-signal-processing units 112 and 222, and in the example of FIG. 3, it is referenced by both. The reference signal output by sequencer circuit 51 is a reference signal different from the reference signal output by BGR circuit 41.

The reference signal output by sequencer circuit 52 is referenced by at least one of (i) ADCs 121 and 211 or (ii) post-signal-processing units 122 and 212, and in the example of FIG. 3, it is referenced by both. The reference signal output by sequencer circuit 52 is a reference signal different from the reference signal output by BGR circuit 42.

Note that although omitted in the present embodiment, the measurement system may include a detection circuit for sequencer circuits 51 and 52 corresponding to the detection circuit for BGR circuits 41 and 42. The detection circuit for sequencer circuits 51 and 52 should confirm at least one of: directly, that the timings of the various trigger signals match; or indirectly, that the counter values of counters inside sequencer circuits 51 and 52 match.

Sequencer circuits 51 and 52 are one example of m reference signal generation circuits. In the present embodiment, sequencer circuit 51 is one example of a third reference signal generation circuit, and sequencer circuit 52 is one example of a fourth reference signal generation circuit.

In the configuration in FIG. 3 described above, in two measurement paths measuring the same measurement object, reference voltages from different BGR circuits 41 and 42 are referenced, and reference signals (for example, trigger signals) from different sequencer circuits 51 and 52 are also referenced. For example, measurement paths 11 and 12 are measurement paths for measuring the same measurement object. Measurement path 11 references reference signals from BGR circuit 41 and sequencer circuit 51, and measurement path 12 references reference signals from BGR circuit 42 and sequencer circuit 52.

When an anomaly occurs in BGR circuits 41 and 42 or sequencer circuits 51 and 52, different reference voltages or reference signals are referenced in the measurement paths, causing a difference in the output measurement data. As a result, both detection circuits 14 and 24 detect there is a failure and output "H" to detection circuit 44A. Detection circuit 44A therefore outputs "H" to processing circuit 5. Assuming that failures do not occur simultaneously in two locations, detection circuits 14 and 24 simultaneously detect there is a failure only when an anomaly occurs in BGR circuits 41 and 42 or sequencer circuits 51 and 52. Stated differently, detection circuit 44A is connected between (i) detection circuits 14 and 24 and (ii) processing circuit 5, and functions as a detection circuit that detects anomalies in BGR circuits 41 and 42 or sequencer circuits 51 and 52 based on the output of detection circuit 14 and the output of detection circuit 24.

FIG. 4 is a block diagram illustrating a circuit configuration of a generalized measurement system according to the present embodiment. Note that to keep the drawing simple, detection circuits 14, 24, and 44A are incorporated into processing circuit 5E, and their illustration is omitted.

When one or more reference signals are used in the two measurement paths 11 and 12 for measuring/processing resistor 10 and the two measurement paths 21 and 22 for measuring/processing resistor 20, two reference signal generation circuits (41 and 42, 51 and 52, ..., n1 and n2) that generate the same or similar reference signals are provided. By having each measurement path reference a reference signal from a different reference signal generation circuit, it becomes possible to detect failures in the reference signal generation circuits based on the outputs of the detection circuits of each measurement path.

In subsequent embodiments and drawings, as illustrated in FIG. 4, the measurement object is generalized and represented as a block. The reference signal generation circuits (for example, BGR circuits, sequencer circuits) and their outputs are collectively represented as single block referred to as "BGR circuit", which is one example of a reference signal generation circuit, with an output referred to as "reference signal".

### [Embodiment 4]

While Embodiment 2 described above pertained to a measurement system that performs failure detection by providing two reference signal generation circuits (for example, BGR circuits 41 and 42) and two measurement paths respectively connected to the measurement objects, the system may include three reference signal generation circuits and three measurement paths respectively connected to the measurement objects. This makes it possible to realize a measurement system capable of identifying locations of failures including the reference signal generation circuit.

FIG. 5A is a block diagram illustrating a circuit configuration of a measurement system according to the present embodiment.

As illustrated in FIG. 5A, the measurement system according to present embodiment includes measurement paths 11, 12, and 13 for measuring/processing resistor 10, measurement paths 21, 22, and 23 for measuring/processing resistor 20, BGR circuits 41, 42, and 43, detection circuits 14, 15, 24, 25, 45, and 46, and processing circuit 6. The reference signals necessary for measurement/processing in each of measurement paths 11, etc., are generated by BGR circuits 41 and 42, where the reference signal output by BGR circuit 41 is referenced by measurement paths 11, 12, and 13, and the reference signal output by BGR circuit 42 is referenced by measurement paths 21, 22, and 23. The reference signal output by BGR circuit 43 is not referenced by any measurement path, including measurement path 11, etc. BGR circuit 43 is configured to be capable of outputting the reference signal output from BGR circuit 41 and the reference signal output from BGR circuit 42, and outputs a reference signal used for detecting failure of BGR circuits 41 and 42. In the present embodiment, BGR circuit 43 is one example of a fifth reference signal generation circuit.

Measurement path 13 is one example of a fifth measurement path, and measurement path 23 is one example of a sixth measurement path. Detection circuit 14 is one example of a first path anomaly detection circuit, detection circuit 15 is one example of a third path anomaly detection circuit, detection circuit 24 is one example of a second path anomaly detection circuit, and detection circuit 25 is one example of a fourth path anomaly detection circuit.

Measurement paths 11, 12, and 13 are connected between resistor 10 and processing circuit 6, and measurement paths 21, 22, and 23 are connected between resistor 20 and processing circuit 6. Detection circuit 14 is connected between (i) measurement paths 11 and 12 and (ii) processing circuit 6, and receives the respective outputs of measurement paths 11 and 12 as its inputs, and detection circuit 15 is connected between (i) measurement paths 12 and 13 and (ii) processing circuit 6, and receives the respective outputs of measurement paths 12 and 13 as its inputs. Detection circuit 24 is connected between (i) measurement paths 21 and 22 and (ii) processing circuit 6, and receives the respective outputs of measurement paths 21 and 22 as its inputs, and detection circuit 25 is connected between (i) measurement paths 22 and 23 and (ii) processing circuit 6, and receives the respective outputs of measurement paths 22 and 23 as its inputs.

Detection circuit 45 is connected between (i) BGR circuits 41 and 43 and (ii) processing circuit 6, and receives the respective outputs of BGR circuits 41 and 43 as its inputs, and detection circuit 46 is connected between (i) BGR circuits 42 and 43 and (ii) processing circuit 6, and receives the respective outputs of BGR circuits 42 and 43 as its inputs.

BGR circuit 41 outputs reference signals used in measurement paths 11, 12, and 13, and BGR circuit 42 outputs reference signals used in measurement paths 21, 22, and 23.

The outputs of measurement paths 11 and 12 are compared in detection circuit 14, and if the difference is within a predetermined value, it is confirmed that neither of measurement paths 11 and 12 is anomalous, and "L" (V14 illustrated in FIG. 5A) is output from detection circuit 14 to processing circuit 6. However, if the difference exceeds the predetermined value, it is detected that either measurement path 11 or 12 is anomalous, and "H" (V14 illustrated in FIG. 5A) is output from detection circuit 14 to processing circuit 6. Similarly, the outputs of measurement paths 12 and 13 are compared in detection circuit 15, and the presence or absence of an anomaly (V15 illustrated in FIG. 5A) is output from detection circuit 15 to processing circuit 6. The outputs of measurement paths 21 and 22 are compared in detection circuit 24, and the presence or absence of an anomaly (V24 illustrated in FIG. 5A) is output from detection circuit 24 to processing circuit 6. The outputs of measurement paths 22 and 23 are compared in detection circuit 25, and the presence or absence of an anomaly (V25 illustrated in FIG. 5A) is output from detection circuit 25 to processing circuit 6.

In this way, detection circuit 14 detects whether or not there are anomalies in measurement paths 11 and 12 based on the outputs of measurement paths 11 and 12, and detection circuit 15 detects whether or not there are anomalies in measurement paths 12 and 13 based on the outputs of measurement paths 12 and 13. Detection circuit 24 detects whether or not there are anomalies in measurement paths 21 and 22 based on the outputs of measurement paths 21 and 22, and detection circuit 25 detects whether or not there are anomalies in measurement paths 22 and 23 based on the outputs of measurement paths 22 and 23. The output of measurement path 12 is input to each of detection circuits 14 and 15, and the output of measurement path 22 is input to each of detection circuits 24 and 25.

Furthermore, the reference voltages output by BGR circuits 41 and 43 are compared in detection circuit 45, and the presence or absence of an anomaly in BGR circuit 41 is output. Stated differently, detection circuit 45 detects where there is an anomaly in BGR circuit 41 based on the output of BGR circuit 41 and the output of BGR circuit 43. Moreover, the reference voltages output by BGR circuits 42 and 43 are compared in detection circuit 46, and the presence or absence of an anomaly in BGR circuit 42 is output. Stated differently, detection circuit 46 detects where there is an anomaly in BGR circuit 42 based on the output of BGR circuit 42 and the output of BGR circuit 43. The reference voltage output by BGR circuit 43 is compared in each of detection circuits 45 and 46, and the presence or absence of an anomaly is output. Processing circuit 6 detects whether there is an anomaly in BGR circuit 43 based on the output of detection circuit 45 and the output of detection circuit 46.

The outputs of each measurement path and each detection circuit are input to processing circuit 6.

From the outputs of each detection circuit 14 and the like, it becomes possible to detect/confirm the presence or absence of a failure and identify the location of the failure as follows. If all circuits are operating normally, all detection circuits 14 and the like output "L". When measurement path 11 fails, only detection circuit 14 outputs "H". When measurement path 12 fails, detection circuits 14 and 15 output "H". When measurement path 13 fails, only detection circuit 15 outputs "H". Similarly, when measurement path 21 fails, only detection circuit 24 outputs "H". When measurement path 22 fails, detection circuits 24 and 25 output "H". When measurement path 23 fails, only detection circuit 25 outputs "H". Moreover, when BGR circuit 41 fails, only detection circuit 45 outputs "H". When BGR circuit 42 fails, only detection circuit 46 outputs "H". When BGR circuit 43 fails, detection circuits 45 and 46 output "H".

FIG. 5B illustrates a truth table in the measurement system of FIG. 5A. The truth table shows the relationship between the outputs ("H" or "L" signals) of each detection circuit 14 and the like and the location of failure. Note that V14, V15, V24, V25, V45, and V46 illustrated in FIG. 5B respectively indicate the outputs ("H" or "L" signals) of detection circuits 14, 15, 24, 25, 45, and 46.

For example, when BGR circuit 41 fails, since the reference signal referenced for measurement/processing is anomalous, the measurement data output by measurement path 11, measurement path 12, and measurement path 13 are unreliable. Therefore, the location of failure in the truth table is indicated as "BGR circuit 41 (measurement paths 11, 12, 13)". Similarly, when BGR circuit 42 fails, the measurement data output by measurement path 21, measurement path 22, and measurement path 23 are unreliable.

When, based on the above truth table, processing circuit 6 detects there is a failure on a measurement path and identifies the failed measurement path, processing circuit 6 takes measures such as issuing a warning that correct detection/measurement cannot be performed on the identified measurement path and notifying a higher-level system. When processing circuit 6 detects there is a failure in a BGR circuit and identifies the failed BGR circuit, even if other detection circuits have not detected there is a failure, processing circuit 6 takes measures such as issuing a warning that the reference signal supplied to the failed BGR circuit and the measurement system connected to it is anomalous, and notifying a higher-level system.

In the measurement system illustrated in FIG. 5A, when measurement paths 11 and 21 have the same measurement purpose (measurement purpose A), measurement paths 12 and 22 have the same measurement purpose (measurement purpose B), and measurement paths 13 and 23 have the same measurement purpose (measurement purpose C), if BGR circuit 41 fails, measurement of resistor 10 cannot be performed, but measurement of resistor 20 can be continued, and if BGR circuit 42 fails, measurement of resistor 20 cannot be performed, but measurement of resistor 10 can be continued. Stated differently, the measurement system illustrated in FIG. 5A can continue measurement even if one of BGR circuits 41 or 42 fails.

In the measurement system illustrated in FIG. 5A, even if one of measurement paths 11, 12, or 13 is detected to have failed, measurement of resistor 10 can be continued using the remaining measurement paths. The same applies to measurement paths 21, 22 and 23.

### [Embodiment 5]

FIG. 6A is a block diagram illustrating a circuit configuration of a measurement system according to the present embodiment. The measurement system illustrated in FIG. 6A is equivalent to the measurement system illustrated in FIG. 5A with a simplified detection circuit.

The measurement system illustrated in FIG. 6A differs from the measurement system illustrated in FIG. 5A in that the reference signal output by BGR circuit 41 is referenced by measurement paths 11 and 21, the reference signal output by BGR circuit 42 is referenced by measurement paths 12 and 22, the reference signal output by BGR circuit 43 is referenced by measurement paths 13 and 23, and detection circuits 45 and 46 are simplified. The measurement system according to the present embodiment does not include detection circuits 45 and 46 illustrated in FIG. 5A. BGR circuit 43 is one example of a third or fifth reference signal generation circuit.

With this configuration, from the outputs of each detection circuit 14 and the like, it becomes possible to detect/confirm the presence or absence of a failure and identify the location of the failure as follows. If all circuits are operating normally, all detection circuits 14 and the like output "L". When measurement path 11 fails, only detection circuit 14 outputs "H". When measurement path 12 fails, detection circuits 14 and 15 output "H". When measurement path 13 fails, only detection circuit 15 outputs "H". Similarly, when measurement path 21 fails, only detection circuit 24 outputs "H". When measurement path 22 fails, detection circuits 24 and 25 output "H". When measurement path 23 fails, only detection circuit 25 outputs "H". Furthermore, when BGR circuit 41 fails, the outputs of measurement paths 11 and 21, which reference the reference signal of BGR circuit 41, become anomalous, so detection circuits 14 and 24 output "H". When BGR circuit 42 fails, detection circuits 14, 15, 24, and 25 output "H". When BGR circuit 43 fails, detection circuits 15 and 25 output "H".

Note that the reference signals output by BGR circuits 41 to 43 are not input to processing circuit 6A.

FIG. 6B illustrates a truth table in the measurement system of FIG. 6A. The truth table shows the relationship between the outputs ("H" or "L" signals) of each detection circuit and the location of failure.

When, based on the above truth table, processing circuit 6A detects there is a failure on a measurement path and identifies the failed measurement path, processing circuit 6A takes measures such as issuing a warning that correct detection/measurement cannot be performed on the identified measurement path and notifying a higher-level system. When processing circuit 6A detects there is a failure in a BGR circuit and identifies the failed BGR circuit, even if other detection circuits have not detected there is a failure, processing circuit 6A takes measures such as issuing a warning that the reference signal supplied to the failed BGR circuit and the measurement system connected to it is anomalous, and notifying a higher-level system.

In the present embodiment, each of measurement paths 11, etc., references a reference signal from a different BGR circuit, enabling detecting failures of the BGR circuits based on the outputs of detection circuits 14, etc., of each of measurement paths 11, etc. Accordingly, the measurement system illustrated in FIG. 6A not only has fewer detection circuits compared to Embodiment 4, but can also prevent at least one of all measurement paths for the same measurement object from being rendered inoperable even if a BGR circuit fails.

Next, another example of the measurement system according to the present embodiment will be described with reference to FIG. 7A and FIG. 7B. FIG. 7A is a block diagram illustrating a first example of another circuit configuration of a measurement system according to the present embodiment. The measurement system illustrated in FIG. 7A is equivalent to the measurement system illustrated in FIG. 6A modified to correspond to a system for a single measurement object (resistor 10). Accordingly, the reference numerals have been changed, and measurement paths 11, 12, 13, 21, 22, and 23 illustrated in FIG. 6A are designated as measurement paths 11A, 12A, 13A, 11B, 12B, and 13B. Note that measurement paths 11, etc., and measurement paths 11A, etc., are, for example, identical in configuration and function.

The reference signal output by BGR circuit 41 is referenced by measurement paths 11A and 11B, the reference signal output by BGR circuit 42 is referenced by measurement paths 12A and 12B, and the reference signal output by BGR circuit 43 is referenced by measurement paths 13A and 13B. Stated differently, BGR circuit 41 is connected to measurement paths 11A and 11B, BGR circuit 42 is connected to measurement paths 12A and 12B, and BGR circuit 43 is connected to measurement paths 13A and 13B.

The outputs of measurement paths 11A and 12A are compared in detection circuit 14A, and if the difference exceeds a predetermined value, it is detected that either measurement path 11A or 12A is anomalous, and "H" is output from detection circuit 14A to processing circuit 6B. Similarly, the outputs of measurement paths 12A and 13A are compared in detection circuit 15A, and the presence or absence of an anomaly is output from detection circuit 15A to processing circuit 6B. The outputs of measurement paths 11B and 12B are compared in detection circuit 14B, and the presence or absence of an anomaly is output from detection circuit 14B to processing circuit 6B. The outputs of measurement paths 12B and 13B are compared in detection circuit 15B, and the presence or absence of an anomaly is output from detection circuit 15B to processing circuit 6B. The outputs of each measurement path and each detection circuit are input to processing circuit 6B.

For example, measurement paths 11A, 12A, and 13A are used for measurement purpose A, and measurement paths 11B, 12B, and 13B are used for measurement purpose B.

FIG. 7B is a truth table in the measurement system of FIG. 7A, showing the relationship between the outputs ("H" or "L" signals) of each detection circuit and the location of failure.

Operations in this configuration of the measurement system are the same as those in FIG. 6A, with only the reference signs for each part being different. Based on the truth table of FIG. 7B, processing circuit 6B notifies a higher-level system of the detection of a failure and the location where the failure was identified, and can continue measurement for both measurement purposes A and B using normally functioning BGR circuits and measurement paths.

In the embodiment illustrated in FIG. 7A, the measurement system also includes fewer detection circuits, can identify the location of failure, and can further prevent at least one of measurement paths from being rendered inoperable. The measurement system imposes two types of measurement purposes on a single measurement object and applies three measurement paths to each measurement purpose, but if there is a failure only at one location, measurement can be performed as usual.

Next, another example of the measurement system according to the present embodiment will be described with reference to FIG. 8A and FIG. 8B. FIG. 8A is a block diagram illustrating a second example of another circuit configuration of a measurement system according to the present embodiment.

FIG. 8A is a circuit block diagram of a measurement system according to yet another example where there is one measurement object. The configuration differs from the configuration of FIG. 7A in that it corresponds to three types of measurement purposes, and measurement system includes measurement paths 11A and 12A for measurement purpose A, measurement paths 11B and 12B for measurement purpose B, and measurement paths 11C and 12C for measurement purpose C. The reference signal output by BGR circuit 41 is referenced by measurement paths 11A and 12B, the reference signal output by BGR circuit 42 is referenced by measurement paths 11B and 12C, and the reference signal output by BGR circuit 43 is referenced by measurement paths 11C and 12A. Stated differently, BGR circuit 41 is connected to measurement paths 11A and 12B, BGR circuit 42 is connected to measurement paths 11B and 12C, and BGR circuit 43 is connected to measurement paths 11C and 12A.

In FIG. 8A, measurement path 11A is one example of a first measurement path, measurement path 11B is one example of a second measurement path, measurement path 11C is one example of a third measurement path, measurement path 12A is one example of a fourth measurement path, measurement path 12B is one example of a fifth measurement path, and measurement path 12C is one example of a sixth measurement path.

Detection circuit 16A is one example of a first path anomaly detection circuit, and has the same functionality as detection circuit 14A illustrated in FIG. 7A. Detection circuit 17A is one example of a second path anomaly detection circuit, and has the same functionality as detection circuit 15A illustrated in FIG. 7A. Detection circuit 16B is one example of a third path anomaly detection circuit, and has the same functionality as detection circuit 14B illustrated in FIG. 7A. Detection circuit 17B is one example of a fourth path anomaly detection circuit, and has the same functionality as detection circuit 15B illustrated in FIG. 7A.

The outputs of measurement paths 11A and 11B are compared in detection circuit 16A, and if the difference exceeds a predetermined value, it is detected that either measurement path 11A or 11B is anomalous, and "H" is output from detection circuit 16A to processing circuit 6C. Similarly, the outputs of measurement paths 11B and 11C are compared in detection circuit 17A, and the presence or absence of an anomaly is output from detection circuit 17A to processing circuit 6C. The outputs of measurement paths 12A and 12B are compared in detection circuit 16B, and the presence or absence of an anomaly is output from detection circuit 16B to processing circuit 6C. The outputs of measurement paths 12B and 12C are compared in detection circuit 17B, and the presence or absence of an anomaly is output from detection circuit 17B to processing circuit 6C. The outputs of each measurement path and each detection circuit are input to processing circuit 6C.

With this configuration, from the outputs of each detection circuit 16A and the like, it becomes possible to detect/confirm the presence or absence of a failure and identify the location of the failure as follows. If all circuits are operating normally, all detection circuits 16A and the like output "L". When measurement path 11A fails, only detection circuit 16A outputs "H". When measurement path 11B fails, detection circuits 16A and 17A output "H". When measurement path 11C fails, only detection circuit 17A outputs "H". Similarly, when measurement path 12A fails, only detection circuit 16B outputs "H". When measurement path 12B fails, detection circuits 16B and 17B output "H". When measurement path 12C fails, only detection circuit 17B outputs "H".

Next, when BGR circuit 41 fails, the outputs of measurement paths 11A and 12B, which reference the reference signal of BGR circuit 41, become anomalous, so detection circuits 16A, 16B, and 17B output "H". When BGR circuit 42 fails, detection circuits 16A, 17A, and 17B output "H". When BGR circuit 43 fails, detection circuits 17A and 16B output "H".

FIG. 8B is a figure showing a truth table in the measurement system of FIG. 8A, showing the relationship between the outputs ("H" or "L" signals) of each detection circuit and the location of failure.

Processing circuit 6C can, based on the truth table of FIG. 8B, notify a higher-level system of the detection of a failure and the location where the failure was identified, and can continue measurement for all of measurement purposes A, B, and C using normally functioning BGR circuits and measurement paths.

In the embodiment illustrated in FIG. 8A, the measurement system also includes fewer detection circuits, can identify the location of failure, and can further prevent at least one of measurement paths from being rendered inoperable. The measurement system imposes three types of measurement purposes on a single measurement object and applies two measurement paths to each measurement purpose, but if there is a failure at one location, measurement can be performed as usual.

As described above, the measurement system according to the present embodiment includes a configuration in which three measurement paths are provided for each measurement object, reference signals from three BGR circuits are allocated to and referenced by each measurement path, and detection circuits are provided to compare two selected pairs from the three measurement paths. This makes it possible to detect/confirm the presence or absence of a failure and identify the location of the failure from the outputs of each detection circuit 16A and the like. When the location of a failure is identifiable, the measurement system can continue measurement even at the presence of the failure by using the normally operating circuits other than the failed location. Furthermore, the measurement system can continue the failure detection as in Embodiment 1 or 2, as three paths or three circuits become two paths or two circuits for measurement.

In summary, in a measurement system including a plurality of measurement paths for detecting a failure, the system includes a plurality of reference signal generation circuits that generate reference signals commonly used by the measurement paths. By referencing reference signals, which are to be input to a failure detection circuit, from reference signal generation circuits of different measurement paths, failure detection can be performed reliably and in a simplified manner.

Note that the measurement systems illustrated in FIG. 6A, FIG. 7A, and FIG. 8A may be integrated into an integrated circuit. For example, in the case of FIG. 6A, the measurement system may further include: a first terminal group including a terminal connected to measurement path 11, a terminal connected to measurement path 12, and a terminal connected to measurement path 13; and a second terminal group including a terminal connected to measurement path 21, a terminal connected to measurement path 22, and a terminal connected to measurement path 23, and the first terminal group, the second terminal group, measurement paths 11 to 13 and 21 to 23, detection circuits 14, 15, 24, and 25, and processing circuit 6A may be integrated into an integrated circuit.

For example, in the case of FIG. 7A, the measurement system may further include: a first terminal group including a terminal connected to measurement path 11A, a terminal connected to measurement path 12A, and a terminal connected to measurement path 13A; and a second terminal group including a terminal connected to measurement path 11B, a terminal connected to measurement path 12B, and a terminal connected to measurement path 13B, and the first terminal group, the second terminal group, measurement paths 11A to 13A and 11B to 13B, detection circuits 14A, 15A, 14B, and 15B, and processing circuit 6B may be integrated into an integrated circuit.

For example, in the case of FIG. 8A, the measurement system may further include: a first terminal group including a terminal connected to measurement path 11A, a terminal connected to measurement path 11B, and a terminal connected to measurement path 11C; and a second terminal group including a terminal connected to measurement path 12A, a terminal connected to measurement path 12B, and a terminal connected to measurement path 12C, and the first terminal group, the second terminal group, measurement paths 11A to 11C and 12A to 12C, detection circuits 16A, 17A, 16B, and 17B, and processing circuit 6C may be integrated into an integrated circuit.

### Other Embodiments

Hereinbefore, a measurement system according to one or more aspects of the present disclosure has been described based on embodiments, but the present disclosure is not limited to these embodiments. Various modifications to the present embodiment that may be conceived by those skilled in the art, as well as embodiments resulting from combinations of elements from different embodiments, may also be included within the scope of one or more aspects of the present disclosure as long as these do not depart from the essence of the present disclosure.

For example, FIG. 1C in Embodiment 1 illustrates a diagram where the configuration of the measurement system is integrated into an integrated circuit, and it was explained that the configurations of the measurement systems illustrated in FIG. 6A, FIG. 7A, and FIG. 8A in Embodiment 5 may also be integrated into integrated circuits. However, the configurations of measurement systems described in other embodiments or illustrated in other figures may also be integrated into integrated circuits.

In the above embodiments, the measurement object is exemplified as a resistor that converts current to be measured into voltage, but the measurement object is not limited to being a resistor. The measurement object may be some other electronic component as long as it can convert the object to be measured into an electrical quantity that can be data-processed, such as voltage.

In the above embodiments, the detection circuit is exemplified as outputting "H" in case of failure and "L" in case of normal operation, but the detection circuit may output "L" in case of failure and "H" in case of normal operation.

The measurement system according to the above embodiments may be implemented as a single device (or a single electronic component), and, alternatively, may be implemented by a plurality of devices (or a plurality of electronic components). When the measurement system is implemented by a plurality of devices (or a plurality of electronic components), the elements included in the measurement system may be distributed among the plurality of devices (or the plurality of electronic components) in any manner. When the measurement system is implemented by a plurality of devices (or a plurality of electronic components), the communication method between the plurality of devices is not particularly limited, and may be wireless or wired communication. A combination of wireless communication and wired communication may be used between the devices.

Each element described in the above embodiments may be implemented as software, and typically, may be implemented as an LSI circuit, which is an integrated circuit. These elements may be integrated into individual chips, or a portion or all of the elements may be integrated into one chip. Although the term LSI is used here, depending on the degree of integration, it may also be referred to as an IC, system LSI, super LSI, or ultra LSI. Furthermore, if a new technology for circuit integration that replaces LSI emerges due to advances in semiconductor technology or other derived technologies, it goes without saying that the elements may be integrated using that technology.

A system LSI circuit is ultra-multifunctional LSI circuit manufactured by integrating a plurality of processing units on a single chip, and specifically, is a computer system including a microprocessor, read only memory (ROM), random access memory (RAM), and the like. The ROM stores a computer program. The microprocessor operates according to the computer program, thereby enabling the system LSI circuit to achieve its functionality.

### [Industrial Applicability]

The present disclosure is applicable in a measurement system, mounted in semiconductor devices, for failure detection/diagnosis of measurement circuits for measuring electrical quantities such as current and voltage.

### [Reference Signs List]

1 battery
2, 3 load circuit
5, 5A, 5B, 5C, 5D, 5E, 6, 6A, 6B, 6C processing circuit
10 resistor (measurement object, first measurement object)
11, 11A, 11B, 11C, 12, 12A, 12B, 12C, 13, 13A, 13B, 21, 22, 23 measurement path
14, 14A, 14B, 15, 15A, 15B, 16, 16A, 16B, 17A, 17B, 24, 25 detection circuit (path anomaly detection circuit)
20 resistor (measurement object, second measurement object)
41, 42, 43 BGR circuit (reference signal generation circuit)
44, 44A, 45, 46 detection circuit (circuit anomaly detection circuit)
51, 52 sequencer circuit (reference signal generation circuit)
100 integrated circuit
101, 102 terminal pair
110, 110A, 110B, 120, 120A, 120B, 210, 220 amplifier
111, 111A, 111B, 121, 121A, 121B, 211, 221 ADC
112, 122, 212, 222 post-signal-processing unit

## Claims

1. A measurement system comprising:
n measurement paths that output measurement data of one or more measurement objects, n being an integer of four or greater;
m reference signal generation circuits that output reference signals to be referenced by the n measurement paths, each of the m reference signal generation circuits outputting a reference signal among the reference signals to two or more measurement paths among the n measurement paths, m being an integer of two or greater;
k path anomaly detection circuits each of which detects/confirms presence or absence of an anomaly by comparing the measurement data output from two measurement paths among the n measurement paths, k being an integer of two or greater; and
a processing circuit that receives the measurement data output from the n measurement paths and detection results output from the k path anomaly detection circuits as its inputs.

2. The measurement system according to claim 1, wherein
the one or more measurement objects include a first measurement object and a second measurement object,
the n measurement paths include:
a first measurement path and a second measurement path that output measurement data of the first measurement object; and
a third measurement path and a fourth measurement path that output measurement data of the first measurement object or the second measurement object,
the m reference signal generation circuits include:
a first reference signal generation circuit that outputs a reference signal to be used by the first measurement path and the third measurement path; and
a second reference signal generation circuit that outputs a reference signal to be used by the second measurement path and the fourth measurement path, and
the k path anomaly detection circuits include:
a first path anomaly detection circuit that detects/confirms presence or absence of an anomaly on the first measurement path and the second measurement path based on an output of the first measurement path and an output of the second measurement path; and
a second path anomaly detection circuit that detects/confirms presence or absence of an anomaly on the third measurement path and the fourth measurement path based on an output of the third measurement path and an output of the fourth measurement path.

3. The measurement system according to claim 2, further comprising:
a circuit anomaly detection unit configured to detect that either the first reference signal generation circuit or the second reference signal generation circuit is anomalous based on an output of the first path anomaly detection circuit and an output of the second path anomaly detection circuit.

4. The measurement system according to claim 2 or 3, wherein
the m reference signal generation circuits further include:
a third reference signal generation circuit that is used by the first measurement path and the third measurement path, and outputs a reference signal different from the reference signal output by the first reference signal generation circuit; and
a fourth reference signal generation circuit that is used by the second measurement path and the fourth measurement path, and outputs a reference signal different from the reference signal output by the second reference signal generation circuit.

5. The measurement system according to any one of claims 2 to 4, wherein
the n measurement paths further include:
a fifth measurement path that outputs measurement data of the first measurement object; and
a sixth measurement path that outputs measurement data of the first measurement object or the second measurement object, and
the k path anomaly detection circuits further include:
a third path anomaly detection circuit that detects/confirms presence or absence of an anomaly on the second measurement path and the fifth measurement path based on the output of the second measurement path and an output of the fifth measurement path; and
a fourth path anomaly detection circuit that detects/confirms presence or absence of an anomaly on the fourth measurement path and the sixth measurement path based on the output of the fourth measurement path and an output of the sixth measurement path.

6. The measurement system according to claim 5, further comprising:
a fifth reference signal generation circuit that outputs a reference signal to be used by the fifth measurement path and the sixth measurement path.

7. The measurement system according to claim 6, wherein
the processing circuit detects that the first reference signal generation circuit is anomalous when only the first path anomaly detection circuit and the third path anomaly detection circuit detect there is an anomaly, detects that the second reference signal generation circuit is anomalous when the first path anomaly detection circuit, the second path anomaly detection circuit, the third path anomaly detection circuit, and the fourth path anomaly detection circuit detect there is an anomaly, and detects that the fifth reference signal generation circuit is anomalous when only the second path anomaly detection circuit and the fourth path anomaly detection circuit detect there is an anomaly.

8. The measurement system according to claim 5, wherein
the first reference signal generation circuit further outputs a reference signal to be used by the fifth measurement path,
the second reference signal generation circuit further outputs a reference signal to be used by the sixth measurement path,
the measurement system further comprises:
a fifth reference signal generation circuit that outputs the reference signal output by the first reference signal generation circuit and the reference signal output by the second reference signal generation circuit;
a first circuit anomaly detection circuit that detects whether the first reference signal generation circuit and the fifth reference signal generation circuit are anomalous based on an output of the first reference signal generation circuit and an output of the fifth reference signal generation circuit; and
a second circuit anomaly detection circuit that detects whether the second reference signal generation circuit and the fifth reference signal generation circuit are anomalous based on an output of the second reference signal generation circuit and the output of the fifth reference signal generation circuit.

9. The measurement system according to claim 1, wherein
the one or more measurement objects include a first measurement object and a second measurement object,
the n measurement paths further include:
a first measurement path, a second measurement path, and a third measurement path that output measurement data of the first measurement object; and
a fourth measurement path, a fifth measurement path, and a sixth measurement path that output measurement data of the first measurement object or the second measurement object,
the m reference signal generation circuits include:
a first reference signal generation circuit that outputs a reference signal to be used by the first measurement path and the fifth measurement path; and
a second reference signal generation circuit that outputs a reference signal to be used by the second measurement path and the sixth measurement path; and
a third reference signal generation circuit that outputs a reference signal to be used by the third measurement path and the fourth measurement path, and
the k path anomaly detection circuits include:
a first path anomaly detection circuit that detects/confirms presence or absence of an anomaly on the first measurement path and the second measurement path based on an output of the first measurement path and an output of the second measurement path; and
a second path anomaly detection circuit that detects/confirms presence or absence of an anomaly on the second measurement path and the third measurement path based on the output of the second measurement path and an output of the third measurement path;
a third path anomaly detection circuit that detects/confirms presence or absence of an anomaly on the fourth measurement path and the fifth measurement path based on an output of the fourth measurement path and an output of the fifth measurement path; and
a fourth path anomaly detection circuit that detects/confirms presence or absence of an anomaly on the fifth measurement path and the sixth measurement path based on the output of the fifth measurement path and an output of the sixth measurement path.

10. The measurement system according to claim 9, wherein
the processing circuit detects that the first reference signal generation circuit is anomalous when the first path anomaly detection circuit, the third path anomaly detection circuit, and the fourth path anomaly detection circuit detect there is an anomaly, detects that the second reference signal generation circuit is anomalous when the first path anomaly detection circuit, the second path anomaly detection circuit, and the fourth path anomaly detection circuit detect there is an anomaly, and detects that the third reference signal generation circuit is anomalous when the second path anomaly detection circuit and the third path anomaly detection circuit detect there is an anomaly.

11. The measurement system according to claim 1, wherein
the one or more measurement objects include a first measurement object and a second measurement object,
the n measurement paths include:
a first measurement path and a second measurement path that output measurement data of the first measurement object; and
a third measurement path and a fourth measurement path that output measurement data of the first measurement object or the second measurement object,
the m reference signal generation circuits include:
a first reference signal generation circuit that outputs a reference signal to be used by the first measurement path and the second measurement path; and
a second reference signal generation circuit that outputs a reference signal to be used by the third measurement path and the fourth measurement path, and
the k path anomaly detection circuits include:
a first path anomaly detection circuit that detects/confirms presence or absence of an anomaly on the first measurement path and the second measurement path based on an output of the first measurement path and an output of the second measurement path; and
a second path anomaly detection circuit that detects/confirms presence or absence of an anomaly on the third measurement path and the fourth measurement path based on an output of the third measurement path and an output of the fourth measurement path.

12. The measurement system according to claim 11, further comprising:
a circuit anomaly detection unit configured to detect that either the first reference signal generation circuit or the second reference signal generation circuit is anomalous based on an output of the first reference signal generation circuit and an output of the second reference signal generation circuit.

13. The measurement system according to claim 3 or 12, further comprising:
a first terminal pair connected to the first measurement path and the second measurement path; and
a second terminal pair connected to the third measurement path and the fourth measurement path, wherein
the first terminal pair, the second terminal pair, the first measurement path, the second measurement path, the third measurement path, the fourth measurement path, the first path anomaly detection circuit, the second path anomaly detection circuit, the circuit anomaly detection unit, and the processing circuit are integrated into an integrated circuit.

14. The measurement system according to any one of claims 5 to 7, further comprising:
a first terminal group connected to the first measurement path, the second measurement path, and the fifth measurement path; and
a second terminal group connected to the third measurement path, the fourth measurement path, and the sixth measurement path, wherein
the first terminal group, the second terminal group, the first measurement path, the second measurement path, the third measurement path, the fourth measurement path, the fifth measurement path, the sixth measurement path, the first path anomaly detection circuit, the second path anomaly detection circuit, the third path anomaly detection circuit, the fourth path anomaly detection circuit, and the processing circuit are integrated into an integrated circuit.

15. The measurement system according to claim 9 or 10, further comprising:
a first terminal group connected to the first measurement path, the second measurement path, and the third measurement path; and
a second terminal group connected to the fourth measurement path, the fifth measurement path, and the sixth measurement path, wherein
the first terminal group, the second terminal group, the first measurement path, the second measurement path, the third measurement path, the fourth measurement path, the fifth measurement path, the sixth measurement path, the first path anomaly detection circuit, the second path anomaly detection circuit, the third path anomaly detection circuit, the fourth path anomaly detection circuit, and the processing circuit are integrated into an integrated circuit.

16. The measurement system according to any one of claims 1 to 15, wherein
the m reference signal generation circuits are bandgap reference circuits and output reference voltages as the reference signals.

17. The measurement system according to any one of claims 1 to 16, wherein
the m reference signal generation circuits are sequencer circuits and output trigger signals as the reference signals.
